# EUROPÄISCHE PATENTANMELDUNG

(11) **EP 2 955 980 A1**
(43) Veröffentlichungstag der Anmeldung: **16.12.2015**
(21) Anmeldenummer: 15158838.1
(22) Anmeldetag: 12.03.2015
(51) Int. Cl.: H05K 1/02, H05K 5/00, H05K 5/06

(54) **LEITERPLATTE MIT EINER HEIZLEITERBAHN ZUM AUSHÄRTEN EINER VERGUSSMASSE**

(30) Priorität: 03.06.2014 DE 102014210461
(71) Anmelder: ROBERT BOSCH GMBH, 70442 Stuttgart (DE)
(72) Erfinder: Liskow, Uwe, 71679 Asperg (DE)

(57) **Zusammenfassung**

Eine Leiterplatte (14) für ein Steuergerät (10) eines Fahrzeugs umfasst Leiterbahnen (28) zum Herstellen von elektrischen Verbindungen zwischen elektrischen Bauelementen (16, 36) der Leiterplatte (14). Eine an der Leiterplatte (14) angebrachte Heizleiterbahn (38) weist Kontaktflächen (40) zum Kontaktieren mit einer Stromquelle (42) auf, so dass eine bei der Heizleiterbahn (28) auf die Leiterplatte (14) aufgetragene Vergussmasse (34) durch Erhitzen der Heizleiterbahn (38) mittels Bestromen durch die Stromquelle (42) aushärtbar ist.

## Beschreibung

### Gebiet der Erfindung

Die Erfindung betrifft eine Leiterplatte, ein Steuergerät für ein Fahrzeug und ein Verfahren zum Aushärten von Vergussmasse auf einer Leiterplatte.

### Hintergrund der Erfindung

Getriebesteuergeräte umfassen in der Regel eine Leiterplatte, auf der elektrische Bauelemente und Baugruppen angeordnet sind. Bei Getriebesteuergeräten, die direkt im Getriebeöl liegen, werden Deckel verwendet, die beispielsweise eine eingelötete Baugruppe bzw. deren Anschlussdrähte, Pins und/oder Lötstellen gegen Metallspäne aus dem Öl schützen, oder es werden Bauelemente wie Entstördrosseln auf der Leiterplatte befestigt, die selbst von Getriebeöl benetzt werden.

Im Allgemeinen können elektrische Bauelemente, wie etwa Drosseln, aber auch Schutzdeckel, über Baugruppen auf einer Leiterplatte mit einem Klebstoff oder Ähnlichem befestigt werden. Dies kann beispielsweise mit Silikonklebern oder mit Acrylklebern geschehen, die einfach und schnell mit UV-Licht ausgehärtet werden können.

Getriebeöle sind jedoch chemisch sehr aggressiv, so dass normalerweise nur Klebstoffe verwendet werden können, die thermisch aushärten. Dazu muss das komplette Getriebesteuergerät beispielsweise 1 Stunde oder länger bei 145 °C oder mehr in einem Aushärteofen gelagert werden.

### Zusammenfassung der Erfindung

Es ist Aufgabe der Erfindung, den Herstellprozess eines Getriebesteuergeräts schneller, einfacher und kostengünstiger zu gestalten.

Diese Aufgabe wird durch den Gegenstand der unabhängigen Ansprüche gelöst. Weitere Ausführungsformen der Erfindung ergeben sich aus den abhängigen Ansprüchen und aus der folgenden Beschreibung.

Ein Aspekt der Erfindung betrifft eine Leiterplatte für ein Steuergerät eines Fahrzeugs. Das Steuergerät kann beispielsweise ein Getriebesteuergerät sein, das nach der Montage am Getriebe direkt Getriebeöl ausgesetzt ist. Derartige Getriebesteuergeräte sind beispielsweise bei Pkws, Lkws und Bussen als Fahrzeuge im Einsatz.

Gemäß einer Ausführungsform der Erfindung umfasst die Leiterplatte Leiterbahnen zum Herstellen von elektrischen Verbindungen zwischen elektrischen Bauelementen der Leiterplatte. Die Leiterplatte weist zusätzlich eine Heizleiterbahn auf, wobei die Heizleiterbahn Kontaktflächen zum Kontaktieren mit einer Stromquelle aufweist, so dass eine bei der Heizleiterbahn auf die Leiterplatte aufgetragene Vergussmasse durch Erhitzen der Heizleiterbahn mittels Bestromen durch die Stromquelle aushärtbar ist.

Mit anderen Worten umfasst die Leiterplatte eine spezielle Leiterbahn, die dazu verwendet wird, auf der Leiterplatte aufgetragene Vergussmasse zu erhitzen. Diese Heizleiterbahn kann über gesonderte Kontaktflächen, die im Betrieb des Steuergeräts nicht mehr verwendet werden, mit einer Stromquelle verbunden werden, über die die Heizleiterbahn erhitzt wird.

Auf diese Weise kann ein teurer Aushärteofen eingespart werden, der zusätzlichen Platz in der Produktionsstraße benötigt, viel Energie benötigt, sehr teuer ist und in der Regel im Batchbetrieb laufen muss. Es werden keine großen Anlagen benötigt, die viel Platz, Investitionsmittel und Energie verbrauchen. Weiter kann vermieden werden, dass das komplette Steuergerät erhitzt und durchwärmt werden muss, obwohl nur bestimmte Bereiche erhitzt werden müssen. Die benötigte Prozesswärme wird nur lokal begrenzt eingebracht. Es wird ein Ankleben von Bauelementen ermöglicht, mit einer Vergussmasse, die Getriebeöl ausgesetzt werden kann.

Eine Vergussmasse kann ein Lack, ein Kleber oder ein Kunststoff sein. Wichtig ist, dass die Vergussmasse durch Erhitzen ausgehärtet werden kann. Beispiele für Vergussmassen sind Epoxidharzsysteme oder Polyurethan-Systeme oder Mischformen aus diesen beiden Komponenten.

Die Heizleiterbahn kann (genauso wie die anderen Leiterbahnen) aus Kupfer gefertigt sein. Die Heizleiterbahn kann blank oder verzinnt sein. Die Heizleiterbahn kann auch mit Lötstopplack oder anderen Schutzsystemen bedeckt sein.

Die Heizleiterbahn kann wie die anderen Leiterbahnen im normalen Leiterplattenherstellprozess auf die Leiterplatte aufgebracht werden.

Gemäß einer Ausführungsform der Erfindung weist die Heizleiterbahn keine elektrische Verbindung zu elektrischen Bauelementen auf der Leiterplatte auf. Um bereits montierte elektrische Bauelemente zu schützen, kann die Heizleiterbahn galvanisch getrennt von den anderen Leiterbahnen auf der Leiterplatte angeordnet werden. Dort, wo auf der Leiterplatte eine Vergussmasse ausgehärtet werden soll, werden auf der Oberfläche der Leiterplatte eine oder mehrere Leiterbahnen aufgebracht (in der obersten Lage der Leiterplatte), die nur zum Aufheizen der darüber liegenden Vergussmasse benötigt werden.

Andererseits ist es aber auch möglich, im Betrieb des Steuergeräts stromführende Leiterbahnen als Heizleiterbahnen zu verwenden.

Gemäß einer Ausführungsform der Erfindung ist die Leiterplatte mehrschichtig aufgebaut und weist Leiterbahnen in wenigstens einer Zwischenschicht auf. In diesem Fall kann die Heizleiterbahn auf der Oberfläche der Leiterplatte vorgesehen sein. Somit kann sich die Heizleiterbahn in direkter Nähe der auszuhärtenden Vergussmasse befinden.

Gemäß einer Ausführungsform der Erfindung weist die Heizleiterbahn einen Heizabschnitt auf, der zum Erhitzen des Klebstoffs ausgeführt ist, und weist einen Zuleitungsabschnitt auf, der einen niedrigeren Widerstand als der Heizabschnitt aufweist. Auf diese Weise kann der Heizstrom, ohne eine Erwärmung der Leiterplatte und deren Umgebung zu verursachen, bis zu der Stelle geleitet werden, die erhitzt werden soll. Eine gezielte Erhitzung eines speziellen Bereichs der Leiterplatte ist möglich.

Der Widerstand des Zuleitungsabschnitts kann beispielsweise mit einem entsprechenden Leitungsquerschnitt (d.h. einer entsprechenden Breite und/oder einer entsprechenden Dicke) vermindert werden. Der Heizabschnitt kann einen geringeren Leitungsquerschnitt aufweisen als der Zuleitungsabschnitt. Es ist auch möglich, dass eine Heizleiterbahn mehrere Heizabschnitte aufweist. Die Zuleitungen zu den eigentlichen Heizabschnitten können einen geringeren Widerstand aufweisen, um Energie zu sparen. Der ausgehärtete Stoff schützt dann auch die Heizleiterbahn selbst.

Gemäß einer Ausführungsform der Erfindung weisen die Kontaktflächen zum Kontaktieren durch die Stromquelle eine größere Breite als die Heizleiterbahn auf. Insgesamt können die Kontaktflächen am Ende der Heizleiterbahn sich inselförmig vergrößern, so dass Elektroden, die mit der Stromquelle verbunden sind, leicht mit der Heizleiterbahn verbunden werden können.

Gemäß einer Ausführungsform der Erfindung weist die Heizleiterbahn einen mäanderförmigen Heizabschnitt auf. Die mäanderförmigen Abschnitte können unter der auszuhärtenden Vergussmasse liegen. Es ist jedoch auch möglich, dass die Heizleiterbahn gerade ist.

Einerseits kann die Vergussmasse als Klebstoff zum Befestigen von Bauelementen auf der Leiterplatte verwendet werden. Weiter können bei einer mehrschichtigen Leiterplatte einzelne Leiterbahnen, die nicht geschützt im Inneren der Leiterplatte verlaufen, sondern auf deren Oberfläche, mit einer hochbeständigen (und deshalb thermisch aushärtenden) Vergussmasse geschützt werden. Bei Getriebesteuermodulen mit einer Leiterplatte, die Getriebeöl ausgesetzt ist, wird in der Regel die oberste Lage nicht zur Verdrahtung bzw. zum Routing verwendet, da diese Bahnen einem erhöhten chemischen Angriff des Öls ausgesetzt sind.

Gemäß einer Ausführungsform der Erfindung verläuft die Heizleiterbahn neben einer mit elektrischen Bauelementen verbundenen Leiterbahn, die auf der Oberfläche der Leiterplatte angeordnet ist, so dass über der mit elektrischen Bauelementen verbundenen Leiterbahn eine Vergussmasse aushärtbar ist, die die Leiterbahn während des späteren Betriebs schützt. Es können auch neben der zu schützenden Leiterbahn (einseitig oder beidseitig) Heizleiterbahnen aufgebracht werden, die mit Heizstrom bestromt werden, wenn die zu schützende Leiterbahn bereits mit einer Elektronik verbunden ist, deren Anschlussleiterbahnen nicht mit den benötigten Heiz-Strömen und -Spannungen beaufschlagt werden dürfen.

Gemäß einer Ausführungsform der Erfindung ist die Heizleiterbahn unter einem Körper eines elektrischen Bauelements angeordnet, so dass der Körper mittels der Vergussmasse an die Leiterplatte befestigbar ist. Auf diese Weise werden andere Bauelemente thermisch kaum belastet.

Gemäß einer Ausführungsform der Erfindung umgibt die Heizleiterbahn eine Befestigungsstelle auf der Leiterplatte für eine elektrische Baugruppe zumindest teilweise, so dass ein Gehäuse (bzw. Schutzdeckel) für die Baugruppe mittels der Vergussmasse an der Leiterplatte befestigbar ist, in dem die Vergussmasse mit der Heizleiterbahn ausgehärtet wird. Auch andere Bauelemente können an der Leiterplatte auf diese Weise befestigt werden.

Ein weiterer Aspekt der Erfindung betrifft ein Steuergerät für ein Fahrzeug, das eine derartige Leiterplatte aufweist. Beispielsweise kann die Leiterplatte die Elektronik eine Getriebesteuerung tragen.

Ein weiterer Aspekt der Erfindung betrifft ein Verfahren zum Aushärten von Vergussmasse auf einer Leiterplatte, beispielsweise zum Herstellen einer Leiterplatte, wie sie obenstehend und untenstehend beschrieben ist. Es ist zu verstehen, dass Merkmale des Verfahrens auch Merkmale der Leiterplatte bzw. des Steuergeräts sein können und umgekehrt.

Gemäß einer Ausführungsform der Erfindung umfasst das Verfahren: Verteilen von thermisch aushärtbarer Vergussmasse bei einer Heizleiterbahn auf der Leiterplatte, Kontaktieren der Heizleiterbahn mit einer Stromquelle, Erhitzen der Heizleiterbahn durch Bestromen mittels der Stromquelle, so dass die Vergussmasse durch die Heizleiterbahn erhitzt wird, und Dekontaktieren der Heizleiterbahn von der Stromquelle, wenn die Vergussmasse ausgehärtet ist.

Während der Produktion der Leiterplatte wird zunächst die Heizleiterbahn (beispielsweise durch Drucken oder Ätzen) an der gewünschten Stelle der Leiterplatte vorgesehen. Anschließend kann die Leiterplatte mit Bauelementen und Baugruppen bestückt werden, wobei auch eine noch nicht ausgehärtete Vergussmasse auf den Stellen verteilt wird, an denen eine Leiterbahn geschützt, ein Bauelement befestigt und/oder ein Deckel über einer Baugruppe befestigt werden soll. Die Kontaktflächen der Heizleiterbahn werden mit einer Stromquelle verbunden, so dass sich die Heizleiterbahn erhitzt und die Vergussmasse aushärtet. Am Ende wird die Stromquelle wieder von der Leiterplatte getrennt.

### Kurze Beschreibung der Figuren

Im Folgenden werden Ausführungsbeispiele der Erfindung mit Bezug auf die beiliegenden Figuren detailliert beschrieben.
Fig. 1 zeigt einen schematischen Querschnitt durch ein Steuergerät gemäß einer Ausführungsform der Erfindung.
Fig. 2 zeigt eine schematische Draufsicht auf eine Leiterplatte gemäß einer Ausführungsform der Erfindung.
Fig. 3 zeigt eine schematische Draufsicht auf eine Leiterplatte gemäß einer weiteren Ausführungsform der Erfindung.

Grundsätzlich sind identische oder ähnliche Teile mit den gleichen Bezugszeichen versehen.

### Detaillierte Beschreibung von Ausführungsbeispielen

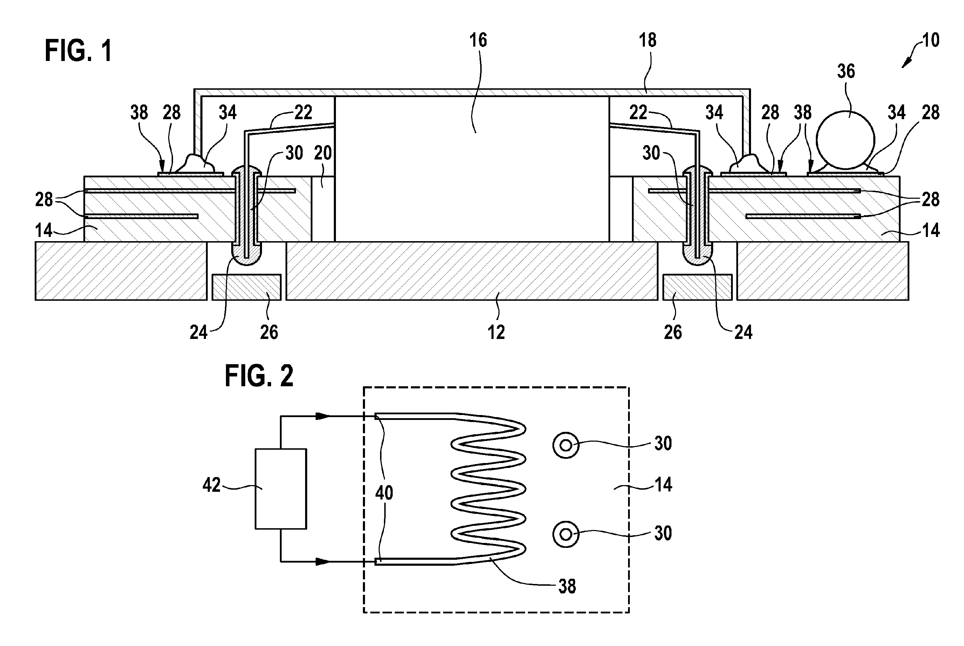

Fig. 1 zeigt ein Getriebesteuergerät 10, das eine Trägerplatte 12 (beispielsweise eine Aluminium-Platte zur Entwärmung), eine Leiterplatte 14, eine Steuerelektronik 16 und einen Gehäusedeckel 18 für die Steuerelektronik 16 umfasst.

Die Leiterplatte 14 ist auf der Trägerplatte 12 montiert und weist eine Öffnung 20 auf, in der die Steuerelektronik 16 aufgenommen ist. Die Steuerelektronik 16 ist auch auf der Trägerplatte 12 montiert und über elektrische Kontakte 22, die mit der Leiterplatte 14 verlötet sind, mit der Leiterplatte 14 elektrisch verbunden.

Die Lötungen 24, die die elektrischen Kontakte 22 mit der Leiterplatte 14 verbinden, werden von einem weiteren Deckel 26 in der Trägerplatte 12 geschützt.

Die Leiterplatte 14 ist mehrschichtig aufgebaut und weist in ihrem Inneren Leiterbahnen 28 auf, die beispielsweise mit Lötaugen 30 verbunden sind und damit mit der Steuerelektronik 16.

Das Getriebesteuergerät 10 kann direkt in einem Getriebe verbaut werden und ist dann direkt heißem Getriebeöl ausgesetzt. Die Deckel 18 und 26 schützen die elektrischen Kontakte 22 vor Spänen aus dem Öl, die Kurzschlüsse erzeugen können.

Der Gehäusedeckel 18 ist mit einer Vergussmasse 34 aufgeklebt. Auf der Leiterplatte 14 ist weiter eine Entstördrossel 36 befestigt, ebenfalls mittels Vergussmasse 34. Zum Aushärten der Vergussmasse weist die Leiterplatte 14 Heizleiterbahnen 38 auf, die auf der Oberfläche der Leiterplatte verlaufen.

Fig. 2 zeigt eine Draufsicht auf einen Ausschnitt der Leiterplatte aus der Fig. 1. In der Fig. 2 ist zu erkennen, dass die Heizleiterbahn 38 Kontaktflächen 40 an den Enden aufweist, über die eine Stromquelle 42 mit der Heizleiterbahn 38 verbunden werden kann.

Nach oder während der Montage des Gehäusedeckels 18 und/oder des Bauelementes 36, hier beispielsweise eine Drossel, werden diese in eine noch nicht ausgehärtete Vergussmasse 34 gebettet, um diese an der Leiterplatte 14 zu fixieren. Nach der Montage werden die Kontaktflächen 40 der Heizleiterbahnen 36, beispielsweise mit Kontaktspitzen in der Montageanlage, elektrisch mit der Stromquelle 42 (etwa einem Heizstromgerät) kontaktiert, um den Heizstrom einzuprägen.

Beispielsweise kann die Heizleiterbahn 38 aus Kupfer gefertigt sein und eine Leiterbahnlänge von 300 mm, eine Leiterbahndicke von 35 µm und eine Leiterbahnbreite von 0,5 mm aufweisen. Während der Montage kann die Heizleiterbahn 38 um 120 K oberhalb der Raumtemperatur, d. h. auf ca. 145 °C aufgeheizt werden. Eine solche Heizleiterbahn 38 hat dann ca. 429 mOhm Widerstand und bekommt einen Strom von ca. 3,5 A eingeprägt, also ca. 5,25 W Leistung. Bei einer dickeren Kupferschicht (typische Werte wie 70 µm oder 400 µm) oder einer breiteren Leiterbahn muss für diese Temperaturen ein entsprechend höherer Strom eingeprägt werden.

Die auszuhärtenden Geräte 10 können in der Taktzeit einer Montagelinie über eine längere Wegstrecke geleitet werden, die zu beispielsweise 1 Stunde Aushärtezeit führt.

Die Temperatur von beispielsweise 145 °C kann bei einer Leiterplatte 14 angewendet werden, die diese Temperaturen ertragen kann, wie beispielsweise eine Leiterplatte 14 mit TG = 165 °C, also einer Leiterplatte 14, die eine Glasübergangstemperatur von 165 °C aufweist. Derartige Leiterplatten vertragen diese Heiztemperaturen mit ausreichend Sicherheitsabstand (hier die Differenz 165 °C - 145 °C). Die Leiterbahnen 28, 38 der Leiterplatte 14 können auch auf Temperaturen bis zur Glasübergangstemperatur aufgeheizt werden.

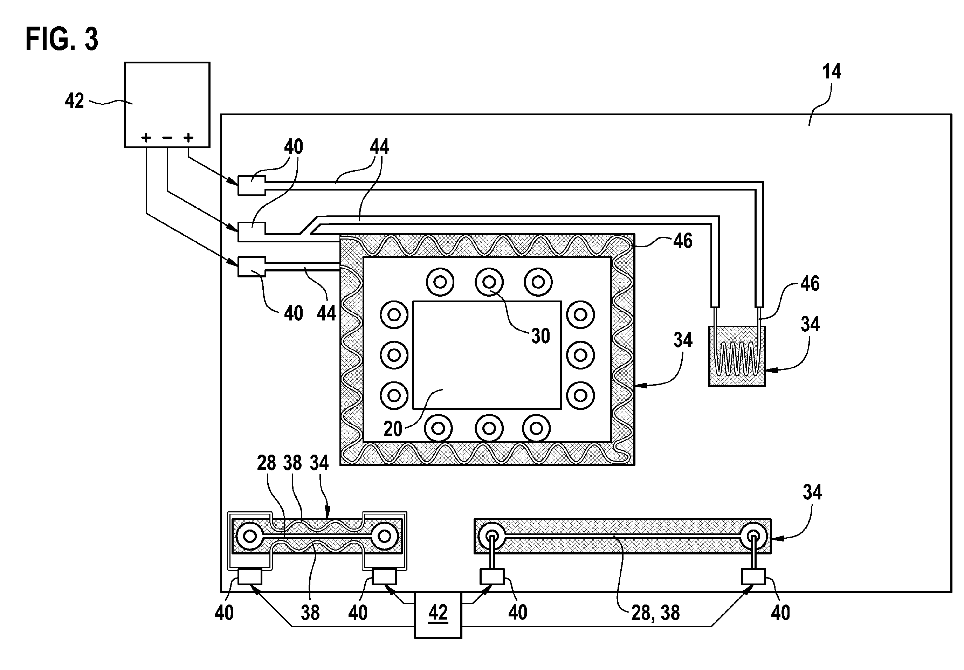

Fig. 3 zeigt eine weitere schematische Draufsicht auf eine Leiterplatte 14 (beispielsweise der Leiterplatte 14 aus der Fig. 1). Es ist zu erkennen, dass die Heizleiterbahnen 38 auf mehrere Heizleiterkreise aufgeteilt sein können.

Eine Heizleiterbahn 38 kann einen (oder mehrere) Zuleitungsabschnitte 44 und einen (oder mehrere) Heizabschnitte 46 aufweisen. Dabei sind lediglich die Heizabschnitte 46 von der Vergussmasse 34 bedeckt. Beispielsweise kann der Heizabschnitt 46 die Öffnung 20 umgeben, um einen Gehäusedeckel 18 zu befestigen. Weiter kann ein Heizabschnitt 46 mäanderförmig ausgeführt sein. Zuleitungsabschnitte 44 weisen einen größeren Leitungsquerschnitt auf als die Heizabschnitte 46. Die Kontaktflächen 40 können eine größere Breite als die Zuleitungsabschnitte 44 aufweisen.

Die Fig. 3 zeigt auch weiter, dass auch normale Leiterbahnen 28 zur Stromleitung während des Betriebs des Geräts 10 auf der Leiterplatte gegen Umwelteinflüsse geschützt werden können. Diese Leiterbahnen 28 werden mit einer thermisch aushärtenden Vergussmasse 34 bedeckt.

Es ist möglich, dass die normale Leiterbahn 28 selbst als Heizleiterbahn 38 verwendet wird. Auch ist möglich, dass neben der Leiterbahn 28 eine oder mehrere Heizleiterbahnen angeordnet sind, die nicht mit der Leiterbahn 28 elektrisch verbunden sind.

In jedem Fall können die Heizleiterbahn 38 bzw. die Leiterbahn 28 selbst über Kontaktflächen 40 elektrisch so hoch bestromt werden, dass sie sich auf beispielsweise 145 °C erhitzt. Nach 1 Stunde ist die Schutzschicht 34 dann ausgehärtet.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Leiterplatte (14) für ein Steuergerät (10) eines Fahrzeugs, die Leiterplatte (14) umfassend:
Leiterbahnen (28) zum Herstellen von elektrischen Verbindungen zwischen elektrischen Bauelementen (16, 36) der Leiterplatte (14);
**gekennzeichnet durch**
eine an der Leiterplatte (14) angebrachte Heizleiterbahn (38), wobei die Heizleiterbahn (38) Kontaktflächen (40) zum Kontaktieren mit einer Stromquelle (42) aufweist, so dass eine bei der Heizleiterbahn (28) auf die Leiterplatte (14) aufgetragene Vergussmasse (34) **durch** Erhitzen der Heizleiterbahn (38) mittels Bestromen **durch** die Stromquelle (42) aushärtbar ist.

2. Leiterplatte (14) nach Anspruch 1,
wobei die Heizleiterbahn (38) keine elektrische Verbindung zu elektrischen Bauelementen (16, 36) auf der Leiterplatte (14) aufweist.

3. Leiterplatte (14) nach Anspruch 1 oder 2,
wobei die Leiterplatte (14) mehrschichtig aufgebaut ist und Leiterbahnen (28) in wenigstens einer Zwischenschicht aufweist; und/oder wobei die Heizleiterbahn (38) auf einer Oberfläche der Leiterplatte (14) vorgesehen ist.

4. Leiterplatte (14) nach einem der vorhergehenden Ansprüche,
wobei die Heizleiterbahn (38) einen Heizabschnitt (46) aufweist, der zum Erhitzen der Vergussmasse (34) ausgeführt ist und einen Zuleitungsabschnitt (44) aufweist, der einen niedrigeren Widerstand als der Heizabschnitt (46) aufweist; und/oder
wobei der Heizabschnitt (46) einen geringeren Leitungsquerschnitt aufweist als der Zuleitungsabschnitt (44).

5. Leiterplatte (14) nach einem der vorhergehenden Ansprüche,
wobei die Kontaktflächen (40) zum Kontaktieren durch die Stromquelle (42) eine größere Breite als die Heizleiterbahn (38) aufweisen.

6. Leiterplatte (14) nach einem der vorhergehenden Ansprüche,
wobei die Heizleiterbahn (38) einen mäanderförmigen Heizabschnitt (46) aufweist.

7. Leiterplatte (14) nach einem der vorhergehenden Ansprüche,
wobei die Heizleiterbahn (38) neben einer mit elektrischen Bauelementen verbundenen Leiterbahn (28) verläuft, die auf der Oberfläche der Leiterplatte (14) angeordnet ist, so dass über der mit elektrischen Bauelementen verbundenen Leiterbahn (28) Vergussmasse aushärtbar ist.

8. Leiterplatte (14) nach einem der vorhergehenden Ansprüche,
wobei die Heizleiterbahn (38) unter einem elektrischen Bauelement angeordnet ist, so dass das elektrische Bauelement mittels der Vergussmasse an die Leiterplatte (14) befestigbar ist; und/oder wobei die Heizleiterbahn (38) eine Befestigungsstelle (20) für eine elektrische Baugruppe zumindest teilweise umgibt, so dass ein Gehäusedeckel (18) für die Baugruppe mittels der Vergussmasse (34) an der Leiterplatte (14) befestigbar ist, in dem die Vergussmasse (34) mit der Heizleiterbahn (38) ausgehärtet wird.

9. Steuergerät (10) für ein Fahrzeug, umfassend:
eine Leiterplatte (14) nach einem der vorhergehenden Ansprüche.

10. Verfahren zum Aushärten von Vergussmasse (34) auf einer Leiterplatte (14), das Verfahren umfassend:
Verteilen von thermisch aushärtbarer Vergussmasse (34) bei einer Heizleiterbahn (38) auf der Leiterplatte (14);
Kontaktieren der Heizleiterbahn (38) mit einer Stromquelle (42);
Erhitzen der Heizleiterbahn (38) durch Bestromen mittels der Stromquelle (42), so dass die Vergussmasse (34) durch die Heizleiterbahn (38) erhitzt wird;
Dekontaktieren der Heizleiterbahn (38) von der Stromquelle (42), wenn die Vergussmasse (34) ausgehärtet ist.
